# EUROPÄISCHE PATENTSCHRIFT

(11) **EP 2 682 501 B1**
(45) Veröffentlichungstag und Bekanntmachung des Hinweises auf die Patenterteilung: **06.12.2017**
(21) Anmeldenummer: 13174499.7
(22) Anmeldetag: 01.07.2013
(51) Int. Cl.: C23C 16/448, B05B 7/14, B05B 12/14, C23C 4/12, C23C 16/513

(54) **PLASMA-BESCHICHTUNGSVORRICHTUNG UND VERFAHREN ZUR PLASMA-BESCHICHTUNG EINES SUBSTRATS**
PLASMA COATING APPARATUS AND METHOD FOR PLASMA COATING A SUBSTRATE
DISPOSITIF DE REVÊTEMENT PAR PLASMA ET PROCÉDÉ DE REVÊTEMENT PAR PLASMA D'UN SUBSTRAT

(30) Priorität: 06.07.2012 DE 102012106078
(43) Veröffentlichungstag der Anmeldung: 08.01.2014
(73) Patentinhaber: Maschinenfabrik Reinhausen GmbH, 93059 Regensburg (DE)
(72) Erfinder: Nettesheim, Stefan, 93051 Regensburg (DE)
(74) Vertreter: Reichert & Lindner Partnerschaft Patentanwälte

(56) Entgegenhaltungen:
- EP-A1- 1 918 420
- WO-A1-2005/018825
- WO-A1-2012/081053
- US-A- 5 332 133
- US-A- 5 340 604
- US-A1- 2007 222 067
- US-A1- 2011 104 369

## Beschreibung

Die Erfindung betrifft eine Plasma-Beschichtungsvorrichtung zur Beschichtung eines Substrates nach dem Oberbegriff von Anspruch 1. Weiterhin betrifft die Erfindung ein Verfahren zur Plasma-Beschichtung eines Substrates.

### Hintergrund der Erfindung

Zur Beschichtung von Substraten sind eine Reihe ganz unterschiedlicher Verfahren und Beschichtungsvorrichtungen bekannt, die je nach dem zu beschichtenden Substrat und der aufzubringenden Schicht, insbesondere auch der Dicke der aufzubringenden Schicht, ausgewählt werden können. Beispiele für Beschichtungsverfahren, die je nach Ausgangszustand des Beschichtungsmaterials eingesetzt werden können sind die Gasphasenabscheidung, das Tauchbeschichten, das Spritzen, das Galvanisieren oder das Pulverbeschichten. Um ein Substrat homogen beschichten zu können bieten sich unterschiedliche Verfahren an. Hierbei kommen insbesondere thermischen Spritzverfahren, das Plasmaspritzen, Niedertemperaturplasmabeschichten oder das Laserpulverauftragen zum Einsatz. Für all diese Verfahren ist es erforderlich, eine kontinuierliche und wohldosierte Pulverzufuhr in eine sogenannte Beschichtungsfackel zu gewährleisten.

### Stand der Technik

Um Schichten mit besonderen Eigenschaften bei einer gleichzeitig geringen thermischen und mechanischen Belastung des zu beschichtenden Substrates zu erreichen, werden besonders feinkörnige Pulver eingesetzt, deren Partikelgrösse im Bereich von 20 µm oder darunter liegen. Das Pulver wird zur Beschichtung des Substrats in die Beschichtungsfackel eingebracht. Allerdings sind derartige feine Pulver schwer zu fördern. Sie neigen außerdem zur Bildung von Agglomeraten, deren Auflösung im Prozessgas nicht gewährleistet ist. Darüber hinaus sind geeignete Pumpen für eine Dispersion von Prozessgas mit hohem Pulveranteil häufig nicht betriebsstabil. Pumpen und Fördermechanismen neigen je nach Pulver zu hohem Verschleiß und zum Verstopfen. Auch die Eigenschaften des Pulvers selbst haben einen erheblichen Einfluss. Besonders kritisch sind hier abrasive Pulver, niedrigschmelzende Pulver und hygroskopische Pulver.

Aus der US 5,853,815 ist ein Verfahren bekannt, ein Substrat homogen zu beschichten, wobei ein Plasmastrom die ganze Breite des Substrates überdeckt. Hierzu ist ein Pulverreservoir über eine Leitung direkt mit einer Plasmaerzeugungseinheit verbunden. Ein großer Druckunterschied zwischen der Plasmabeschichtungsfackel der Plasmaerzeugungseinheit und der Umgebung der Plasmabeschichtungsfackel erzeugt ein Schockmuster, das dazu führt, dass sowohl der Beschichtungsstrom breit gefächert, wie auch das Beschichtungsmaterial gut im Plasmastrom verteilt wird.

In der DE 198 26 550 C2 wurde daher bereits vorgeschlagen, das Pulver mit mechanischen Mitteln aus einem Vorratsbehälter zu entnehmen und über ein Trägergas in ein Pulveraerosol zu überführen. Das Pulveraerosol kann anschließend in einem Behälter mit Ultraschall beaufschlagt werden, wobei vorhandene Agglomerate von Partikeln aufgelöst werden. Dieses Verfahren ist allerdings sehr aufwendig und für Pulver mit Verklumpungsneigung nicht hinreichend prozesssicher.

Aus dem Stand der Technik, wie z.B. DE 102 16 924 A1, DE 10 2005 032 711 A1, US 2007/059436 A1, US 4,109,027 A, DE 43 28 021 A1, EP 0 120 810 A1 oder WO 2010/060646 A1, sind Beschichtungsvorrichtungen bzw. Beschichtungsverfahren bekannt, die kein Plasma verwenden und somit kein Beschichtungsmaterial (Pulver) in die Plasmabeschichtungsfackel einbringen. Ebenso ist das Problem der konstanten Förderrate des Beschichtungsmaterials nicht angesprochen.

Aus der US 5,340,604 A ist eine Vorrichtung und ein Verfahren zur Beschichtung mehrerer Gegenstände mit einem Film, der aus mehreren Bestandteilen besteht, bekannt. Das Pulvergemisch wird in einen zylindrischen Reaktionsraum induziert, in dem ein thermisches Plasma gezündet wird. Im Reaktionsraum schlägt sich das Pulvergemisch auf dem zu beschichtenden Element nieder.

Die WO 2012/081053 offenbart eine Vorrichtung, mit der Partikel zu Beschichtung eines Substrats elektrische aufgeladen werden, damit sich diese auf einem Substrat in einer Prozesskammer niederschlagen können.

Aus der US 5,332,133 ist eine Mischvorrichtung für Pulver bekannt, um eine einheitliche Schicht auf ein Substrat zu sprühen. Die WO 2005/018825 offenbart ein Interface für einen Bediener, um den Sprühauftrag von Pulver zu steuern. Aus der US-Patentanmeldung US 2007/0222067 ist ein dielektrisches Bauelement bekannt, das mittels eines Aerosol-Sprühauftrags auf einem Substrat hergestellt wird.

Aufgabe der vorliegenden Erfindung ist eine Plasma-Beschichtungsvorrichtung und ein Verfahren vorzuschlagen, mit dem es möglich ist, ein Pulver oder ein Pulver/Prozessgasgemisch von einem Pulverreservoir in eine Prozesskammer zu fördern, wobei eine homogene, präzise dosierte, pulsationsfreie und zeitstabile Pulverförderung zwischen dem Pulverreservoir und der Prozesskammer gewährleistet ist.

Erfindungsgemäß wird diese Aufgabe durch eine Plasma-Beschichtungsvorrichtung zur Beschichtung eines Substrats mit den Merkmalen von Anspruch 1 gelöst. Im Hinblick auf das Verfahren wird die Aufgabe durch ein Verfahren zur Beschichtung eines Substrats mit den Merkmalen gemäß Anspruch 11 gelöst.

Vorgeschlagen wird also eine Plasma-Beschichtungsvorrichtung zur Beschichtung eines Substrates mit Partikeln aus einem Partikelreservoir, einer Dosiervorrichtung zum Dosieren der im Partikelreservoir untergebrachten Partikel, einer Transportleitung und einer allseitig geschlossenen Prozesskammer. In der Prozesskammer herrscht ein Prozesskammerdruck P1. Im Partikelreservoir herrscht ein Partikelreservoirdruck P2, wobei der Prozesskammerdruck P1 kleiner ist, als der Partikelreservoirdruck P2. Hierzu ist zumindest eine Saugpumpe mit der Prozesskammer verbunden ist, wodurch ein Druckgradient ΔP zwischen der Prozesskammer und dem Partikelreservoir einstellbar ist. Mittels der Transportleitung werden aus dem Partikelreservoir die Pulverpartikel zu einer Plasmabeschichtungsfackel in der Prozesskammer geleitet. Dieser Transport ist genau einstellbar, so dass mechanisch oder pneumatisch bedingte Partikel-Aggregate in der Transportleitung vermeidbar sind.

In einer bevorzugten Ausführungsform der Erfindung ist das Partikelreservoir der Plasma-Beschichtungsvorrichtung in einer Dosierkammer vorgesehen, wobei die Dosiervorrichtung mit der allseitig geschlossenen Prozesskammer über die Transportleitung verbunden ist. Bedingt durch ihre unterschiedlichen Aufgaben ist die Prozesskammer von der Dosierkammer funktional getrennt.

Um den Prozesskammerdruck P1 einstellen und verändern zu können kann eine Absaugleitung und eine Saugpumpe vorgesehen werden, wobei die Absaugleitung mit der Prozesskammer und einer Saugpumpe verbunden ist. Weiterhin kann ein Drosselventil zum Ändern des auf die Prozesskammer wirkenden Absaugluftstroms vorgesehen werden. Dabei wird das Drosselventil zwischen der Absaugleitung und der Saugpumpe angeordnet.

In einer weiteren Ausführungsform der Erfindung kann ein Filter zum Filtern des aus der Prozesskammer abgesaugten Absaugluftstroms vorgesehen werden wobei der Filter zwischen der Absaugleitung und der Saugpumpe, bevorzugt luftstromabwärts nach dem Drosselventil angeordnet ist. Dabei wird im Rahmen der vorliegenden Anmeldung unter dem Begriff Absaugluftstrom der Strom des aus der Prozesskammer abgesaugten Partikel/Gas - Gemisches verstanden.

Der Differenzdruck zwischen dem Partikelkammerdruck P2 und dem Prozesskammerdruck P1 wird so eingestellt, dass er zwischen 50 mbar und 1000 mbar und bevorzugt bei 200 mbar liegt. Hierzu wird in der Dosierkammer ein Partikelkammerdruck P2 (absolut) zwischen 900 mbar und 1500 mbar eingestellt. In der Prozesskammer wird der Prozesskammerdruck P1 (absolut) auf höchstens 1013 mbar eingestellt und liegt bevorzugt bei weniger als 500 mbar und besonders bevorzugt bei 30 mbar.

Die Dosiervorrichtung kann eine bewegliche Sauglanze aufweisen, die in das Partikelreservoir hineinreicht, was besonders dann vorteilhaft ist wenn die Beschichtungsvorrichtung als Plasma-Beschichtungsvorrichtung ausgeführt ist, die in der Prozesskammer eine Plasmabeschichtungsfackel aufweist.

Im Hinblick auf das erfindungsgemäße Verfahren werden zur Beschichtung eines Substrates aus einem Partikelreservoir Partikel mit einer Dosiervorrichtung dosiert entnommen. Diese werden über eine Transportleitung einer Prozesskammer zugeführt. Zwischen der Prozesskammer und dem Partikelreservoir wird ein Druckgradient ΔP eingestellt, der dann eine Förderrate von Partikeln bestimmt.

Hierbei kann in einer bevorzugten Ausführungsform der Erfindung der Druckgradient ΔP durch eine Absaugung der Prozesskammer erzeugt werden. Ebenso dann der Druckgradient ΔP durch die Stärke der Absaugung eingestellt wird.

Mit der vorgeschlagenen Plasma-Beschichtungsvorrichtung zur Beschichtung eines Substrates kann darauf verzichtet werden, in der Pulverleitung zwischen Pulverreservoir und Prozesskammer ein Pumpaggregat anzuordnen. Darüber hinaus können mechanische und pneumatische Aggregate auf dem Transportstrang vermieden werden.

Weitere Vorteile und vorteilhafte Ausgestaltungen der Erfindung sind Gegenstand der nachfolgenden Figuren sowie deren Beschreibungsteile.

Es zeigen im Einzelnen:
- **Figur 1:**: schematisch eine erste Ausführungsform der erfindungsgemäßen Plasma-Beschichtungsvorrichtung;
- **Figur 2:**: schematisch eine weitere Ausführungsform der erfindungsgemäßen Plasma-Beschichtungsvorrichtung;
- **Figur 3:**: schematisch eine weitere Ausführungsform der erfindungsgemäßen Plasma-Beschichtungsvorrichtung; und
- **Figur 4:**: schematisch eine weitere Ausführungsform der erfindungsgemäßen Plasma-Beschichtungsvorrichtung

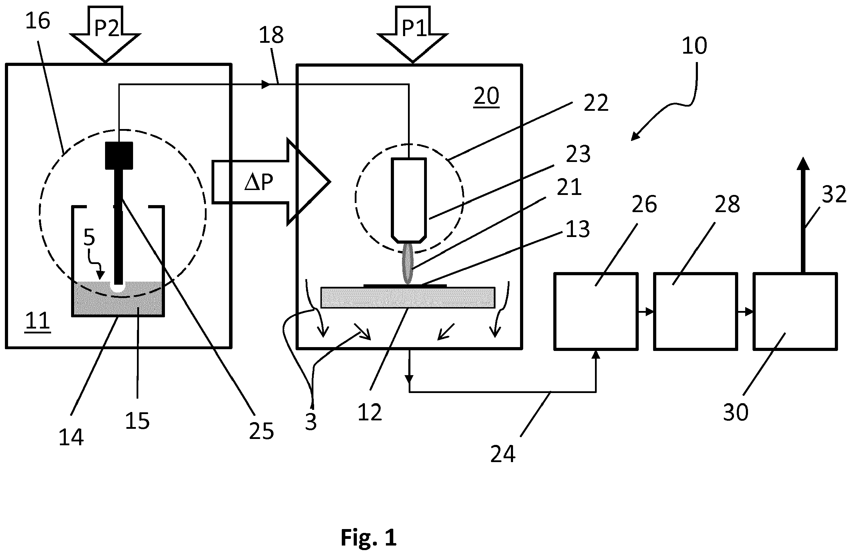

In **Figur 1** ist eine erste Ausführungsform der erfindungsgemäßen Plasma-Beschichtungsvorrichtung 10 dargestellt. Die Plasma-Beschichtungsvorrichtung 10 weist eine Dosierkammer 11 auf. In der Dosierkammer 11 ist eine Dosiervorrichtung 16 vorgesehen, die ein Partikelreservoir 14 aufweist, in das Partikel 15 eingebracht sind, die zur Beschichtung des Substrates 12 verwendet werden. Weiterhin ist in der Dosiervorrichtung 16 eine Vereinzelungseinrichtung vorgesehen, mit deren Hilfe Partikel 15 aus dem Partikelreservoir 14 entnommen werden können. Diese kann beispielsweise als Sauglanze 25 ausgeführt sein, die in das Partikelreservoir 14 hineinreicht. Dabei kann die Sauglanze 25 in den Partikelvorrat eintauchen oder etwas von der Oberfläche 5 des Partikelvorrats beabstandet sein. Die Sauglanze 25 wird mit einem nicht dargestellten Verschiebemechanismus über der Oberfläche 5 des Partikelvorrats verfahren, um so zusätzlich eine konstante Förderrate der Partikel 15 zu gewährleisten. In einer Prozesskammer 20 erfolgt das Beschichten des Substrates 12. Dabei wird eine Beschichtung 13 auf das Substrat 12 aufgebracht, wobei Partikel 15 auf dem Substrat 12 abgelagert werden. Um die Partikel 15 auf dem Substrat 12 ablagern zu können, ist die Dosiervorrichtung 16 über eine Transportleitung 18 mit der Prozesskammer 20 verbunden, so dass die Partikel 15 von der Dosierkammer 11 in die Prozesskammer 20 gefördert werden.

Erfindungsgemäß erfolgt die Förderung der Partikel 15 von der Dosiereinrichtung 16 zur Prozesskammer 20 dadurch, dass ein Druckgradient ΔP zwischen der Prozesskammer 20 und Dosierkammer 11, die funktionell voneinander unabhängig sind, geeignet eingestellt wird. Hierzu wird in der Prozesskammer 20 ein Prozesskammerdruck P1 und in dem Partikelreservoir 14 ein Partikelreservoirdruck P2 eingestellt, wobei der Prozesskammerdruck P1 kleiner ist als der Partikelreservoirdruck P2. Da sich die Größe des Druckgradienten ΔP einstellen lässt, kann damit die daraus resultierende Förderrate genau festgelegt werden. Auf diese Weise wird es möglich, die Bildung mechanisch und pneumatisch bedingter Partikel-Agglomerate auf dem Transportweg der Partikel 15 zum Substrat 12 zu vermeiden, so dass eine homogene, präzise dosierte, pulsationsfreie und sichere Pulverförderung zwischen dem Partikelreservoir 14 und der Prozesskammer 20 erreicht wird.

Der Druckgradient ΔP zwischen der Prozesskammer 20 und dem Partikelreservoir 14 kann dadurch eingestellt werden, dass die Prozesskammer 20 mit einer Absaugleitung 24 versehen wird. Die Absaugleitung 24 wird mit einer Saugpumpe 30 verbunden, die in der Prozesskammer 20 einen Prozesskammerdruck P1 erzeugt, der kleiner ist als der in der Dosierkammer 11 herrschende Partikelreservoirdruck P2. Die Saugpumpe 30 wird entsprechend gesteuert, damit der Druckgradient ΔP zwischen der Prozesskammer 20 und dem Partikelreservoir 14 auf dem eingestellten Niveau innerhalb vorgegebener Grenzen gehalten werden kann.

Der mit der Saugpumpe 30 erzeugte Prozesskammerdruck P1 beträgt absolut höchstens 1013 mbar und liegt bevorzugt bei weniger als 500 mbar. Besonders bevorzugt wird ein Prozesskammerdruck P1 von etwa 30 mbar erzeugt. Damit ist es ebenfalls möglich, das in der Prozesskammer 20 anfallende überschüssige Material, wie z. B. loses Beschichtungspulver, das nicht an der Beschichtung 13 haftet, sowie das Prozessgas mittels einer sich einstellenden Absaugströmung 3 abzusaugen. In der Dosierkammer 11 herrscht ein Partikelreservoirdruck P2, der absolut zwischen 900 mbar und 1500 mbar liegt.

Durch eine geeignete Kombination der Absaugung der Prozesskammer 20 mit dem Dosier- und Fluidisierprozess, kann damit ein Druckgradient ΔP zwischen den beiden funktional getrennten Kammern (Prozesskammer 20 und Dosierkammer 11) aufgebaut und die Förderrate der Partikel 15 genau eingestellt werden. Die Versorgung des Beschichtungsprozesses mit dem aufzutragenden Material, z.B. dem Pulver zur Beschichtung wird damit durch den Druckgradienten ΔP bestimmt und kann durch eine Veränderung des Druckgradienten ΔP geregelt werden. Damit kann der Dosier- und Fluidisierungsprozess kontrolliert werden. Der Druckgradient ΔP wird dabei so eingestellt, dass die Differenz zwischen dem Partikelreservoirdruck P2 und dem Prozesskammerdruck P1 zwischen 50 mbar und 1000 mbar, bevorzugt bei 200 mbar liegt.

Zur Steuerung oder Regelung des Differenzdrucks kann weiterhin ein Drosselventil 26 vorgesehen werden, das stromabwärts der Absaugleitung 24 vorgesehen ist. Mit dem Drosselventil 26 kann die auf die Prozesskammer 20 wirkende Saugleistung der Saugpumpe 30 verändert werden, ohne dass die Saugleistung der Saugpumpe 30 verändert werden müsste. Dies ermöglicht eine rasche Änderung der auf die Prozesskammer 20 wirkenden Saugleistung und damit auch eine Regelung des Systems. Die Regelung kann mit zusätzlichen Komponenten, wie geeigneten Sensoren (nicht dargestellt) und gegebenenfalls einer Steuereinheit automatisiert werden. Zusätzlich kann ein Filter 28 der Saugpumpe 30 vorgelagert werden, so dass ein unerwünschtes Ablagern von Partikeln 15 in der Saugpumpe 30 vermieden wird. Die abgesaugte Luft kann über einen Auslass 32 aus der Saugpumpe 30 abgeführt werden. Die Saugpumpe 30 und das Drosselventil 26 werden entsprechend abgestimmt gesteuert, damit der Druckgradient ΔP zwischen der Prozesskammer 20 und dem Partikelreservoir 14 auf dem eingestellten Niveau innerhalb vorgegebener Grenzen gehalten werden kann.

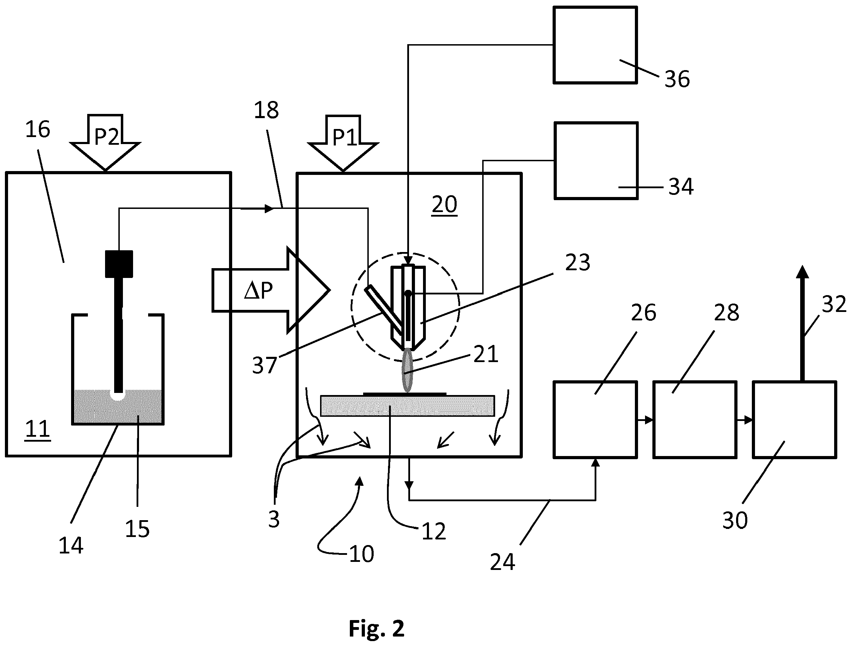

**Figur 2** zeigt schematisch eine Ausführungsform der Erfindung in der ein Substrat 12 mit einer Plasma-Beschichtungsvorrichtung 10 beschichtet wird. Hierzu werden die Partikel 15 aus der Dosierkammer 11 gefördert, wobei die Prozesskammer 20 gegenüber der Dosierkammer 11 auf einem niedrigeren Druckniveau liegt. Die Partikel 15 werden über die Transportleitung direkt in eine Plasmabeschichtungsdüse 23 geleitet und in die Plasmabeschichtungsfackel 21, in diesem Fall einem Plasmastrahl, injiziert und treffen so auf das zu beschichtende Substrat 12. Wie bereits beschrieben kann der Druckgradient ΔP zur Steuerung der Dosierung der Menge an geförderten Partikeln 15 über eine Saugpumpe 30 eingestellt werden, der wiederum ein Drosselventil 26 und ein Filter 28 vorgelagert sein können. Als zusätzliche Komponenten können eine elektrische Stromversorgung 34 und eine Prozessgasversorgung 36 in der Prozesskammer 20 vorgesehen sein. Bevorzugt werden diese mit der Plasmabeschichtungsdüse 23 verbunden. Ebenso werden der Plasmabeschichtungsdüse 23 über eine Zuführung 37 die Partikel 15 aus dem Partikelreservoir 14 übergeben.

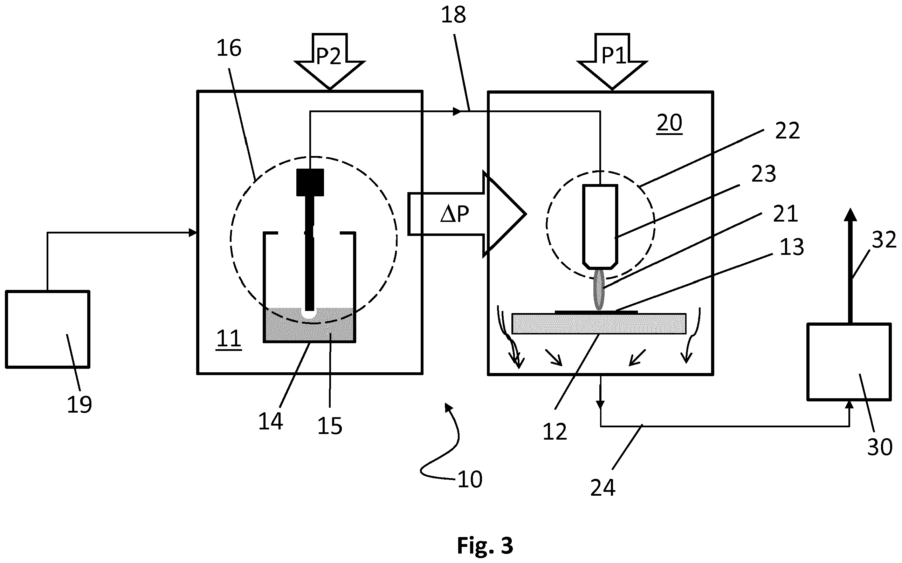

**Figur 3** zeigt eine erfindungsgemäße Plasma-Beschichtungsvorrichtung 10 in einer weiteren Ausführungsform. Dabei wird der aus den Figuren 1 und 2 bekannte Aufbau um eine Druckpumpe 19 ergänzt, die mit der Dosierkammer 11 verbunden wird. Die Druckpumpe 19 kann zur Unterstützung eingesetzt werden, um einen hinreichenden Druckgradienten ΔP zwischen der Prozesskammer 20 und der Dosierkammer 11 zu erreichen. Damit steht neben der Saugpumpe 30 eine weitere Möglichkeit zur Verfügung, den Partikelstrom von der Dosierkammer 11 zur Prozesskammer 20 zu steuern. Mit dieser Anordnung kann ein Überdruck-Beschichtungsprozess realisiert werden, bei dem der Druck in der Dosierkammer 11 größer als der Normaldruck der Umgebung ist. Auch in dieser Ausführungsform kann das in den Figur 1 und 2 dargestellten Drosselventil 26 und der Filter 28 vorgesehen werden.

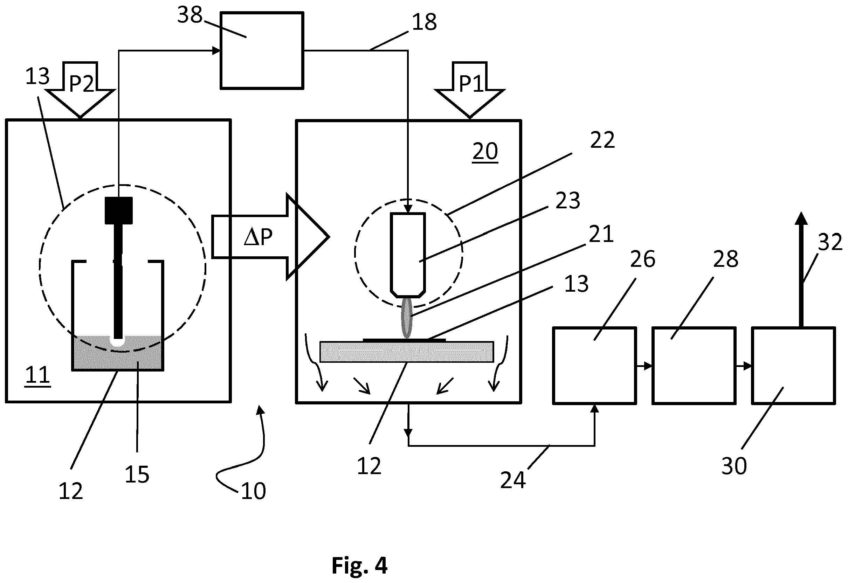

In **Figur 4** zeigt eine erfindungsgemäße Plasma-Beschichtungsvorrichtung 10 in einer weiteren Ausführungsform. In dieser Ausführungsform wird der aus den Figuren 1, 2 oder 3 bekannte Aufbau um ein Transportleitungselement 38 erweitert, wobei dieses in der Transportleitung 18 vorgesehen wird. Das Transportleitungselement 38 kann vorgesehen werden, um die den Druckgradienten ΔP zwischen der Dosierkammer 11 und der Prozesskammer 20 weiter zu stabilisieren. Hierzu kann das Transportleitungselement 38 auf zwei Arten realisiert werden. In einer ersten Ausführungsform wird es als Stützpumpe ausgeführt, mit deren Hilfe der Druckgradient ΔP zwischen der Dosierkammer 11 und der Prozesskammer 20 durch einen zusätzlichen Stützdruck, der in Richtung der Prozesskammer 20 wirkt, stabilisiert werden kann. Damit kann eine stabile Förderrate von Partikeln 15 weiter unterstützt werden. In einer zweiten Ausführungsform kann das Transportleitungselement 38 kann auch als Drossel ausgeführt werden, um einem zu großen Druckgradienten ΔP zwischen der Dosierkammer 11 und der Prozesskammer 20 entgegenzuwirken. Bevorzugt ist die Drossel dabei in ihrer Drosselwirkung einstellbar. Mit Hilfe geeigneter Mess-, Sensor- und Regelungseinrichtungen lässt sich hierbei auch eine automatisierte Einstellung oder Regelung der Drossel beziehungsweise der Stärke der Stützwirkung der Stützpumpe erreichen. Die Saugpumpe 30, das Transportleitungselement 38 und das Drosselventil 26 werden entsprechend abgestimmt gesteuert, damit der Druckgradient ΔP zwischen der Prozesskammer 20 und dem Partikelreservoir 14 auf dem eingestellten Niveau innerhalb vorgegebener Grenzen gehalten werden kann und eine konstante Förderrate des Pulvers aus dem Pulverreservoir gewährleistet ist.

Die Erfindung wurde unter Bezugnahme auf bevorzugte Ausführungsformen beschrieben. Es ist für einen Fachmann jedoch selbstverständlich, dass der Schutzbereich der nachstehenden Ansprüche Änderungen und Abwandlungen der Erfindung sowie Kombinationen technischer Merkmale, die bezüglich verschiedener Ausführungsformen offenbart sind, umfasst.

### Bezugszeichenliste:

- 3: Absaugströmung
- 5: Oberfläche
- 10: Plasma-Beschichtungsvorrichtung
- 11: Dosierkammer
- 12: Substrat
- 13: Beschichtung
- 14: Partikelreservoir
- 15: Partikel
- 16: Dosiervorrichtung
- 18: Transportleitung
- 19: Druckpumpe
- 20: Prozesskammer
- 21: Plasmabeschichtungsfackel
- 22: Beschichtungskopf
- 23: Plasmabeschichtungsdüse
- 24: Absaugleitung
- 25: Sauglanze
- 26: Drosselventil
- 28: Filter
- 30: Saugpumpe
- 32: Auslass
- 34: elektrische Stromversorgung
- 36: Prozessgasversorgung
- 37: Zuführung
- 38: Transportleitungselement
- P1: Prozesskammerdruck
- P2: Partikelreservoirdruck
- ΔP: Druckgradient

## Patentansprüche

1. Plasma-Beschichtungsvorrichtung (10) zur Beschichtung eines Substrates (12) mit Partikeln (15) aus einem Partikelreservoir (14), einer Dosiervorrichtung (16) zum Dosieren der im Partikelreservoir (14) bevorrateten Partikel (15), mindestens einer Transportleitung (18) und einer allseitig geschlossenen Prozesskammer (20), **dadurch gekennzeichnet, dass** eine Absaugleitung (24) mit der Prozesskammer (20) verbunden ist, wobei eine Saugpumpe (30) der Absaugleitung (24) zugeordnet ist und ein Drosselventil (26) der Saugpumpe (30) vorgeordnet ist wodurch ein Druckgradient (ΔP) zwischen der Prozesskammer (20) und dem Partikelreservoir (14) derart einstellbar ist, dass in der Prozesskammer (20) ein Prozesskammerdruck (P1) und in dem Partikelreservoir (14) ein Partikelreservoirdruck (P2) herrscht, wobei der Prozesskammerdruck (P1) kleiner ist, als der Partikelreservoirdruck (P2) und eine Plasmabeschichtungsdüse (23) in der Prozesskammer (20) mit der Transportleitung (18) aus dem Partikelreservoir (14) verbunden ist.

2. Plasma-Beschichtungsvorrichtung (10) nach Anspruch 1, **wobei** die Dosiervorrichtung (16) in einer Dosierkammer (11) untergebracht ist und mit der Prozesskammer (20) über die Transportleitung (18) verbunden ist.

3. Plasma-Beschichtungsvorrichtung (10) nach Anspruch 2, **wobei** die Prozesskammer (20) von der Dosierkammer (11) räumlich getrennt ist.

4. Plasma-Beschichtungsvorrichtung (10) nach Anspruch 3, **wobei** mindestens ein Filter (28) zwischen dem Drosselventil (26) und der Saugpumpe (30) angeordnet ist.

5. Plasma-Beschichtungsvorrichtung (10) nach einem der Ansprüche 1 - 4, **wobei** der Differenzdruck zwischen dem Partikelreservoirdruck (P2) und dem Prozesskammerdruck (P1) zwischen 50 mbar und 1000 mbar. liegt.

6. Plasma-Beschichtungsvorrichtung (10) nach einem der Ansprüche 1 - 5, **wobei** der Partikelreservoirdruck (P2) zwischen 900 mbar und 1500 mbar liegt.

7. Plasma-Beschichtungsvorrichtung (10) nach einem der Ansprüche 1 - 6, **wobei** die Dosiervorrichtung (16) eine bewegliche Sauglanze (25) aufweist, die in das Partikelreservoir (14) hineinreicht und mit der Transportleitung (18) verbunden ist.

8. Plasma-Beschichtungsvorrichtung (10) nach einem der Ansprüche 1 - 7, **wobei** der Dosierkammer (11) eine zusätzliche Stützpumpe (19) zugeordnet ist, die auf die Dosierkammer (11) wirkt.

9. Plasma-Beschichtungsvorrichtung (10) nach einem der Ansprüche 1 - 7, **wobei** in der Transportleitung (18) ein Transportleitungselement (38) vorgesehen ist.

10. Plasma-Beschichtungsvorrichtung (10) nach Anspruch 9, **wobei** das Transportleitungselement (38) eine Stützpumpe oder eine Drossel ist.

11. Verfahren zur Plasma-Beschichtung eines Substrates (12) **gekennzeichnet durch** die folgenden Schritte:
• dass in einem Partikelreservoir (14) Partikel mit einer Dosiervorrichtung (16) mittels einer beweglichen Sauglanze (25) dosiert entnommen werden;
• dass der Prozesskammer (20), in der eine Plasmabeschichtungs-fackel (21) vorgesehen ist, über eine Transportleitung (18) die Partikel (15) zugeführt werden;
• das in der Prozesskammer (20) das Substrat (12) beschichtet wird, und Partikel (15) sich auf dem Substrat (12) ablagern;
• dass über eine mit der Prozesskammer (20) verbundene Absaugleitung (24) mit einer Saugpumpe (30), der ein Drosselventil (26) vorgeordnet ist, ein Druckgradient (ΔP) zwischen der Prozesskammer (20) und dem Partikelreservoir (14) eingestellt wird,
• wobei der Druckgradient (ΔP) eine Förderrate von Partikeln (15) zu der Plasmabeschichtungsfackel (21) in der Prozesskammer (20) bestimmt.

12. Verfahren nach Anspruch 11, **wobei** der Druckgradient (ΔP) durch die Stärke der Absaugung eingestellt wird.

13. Verfahren nach einem der Ansprüche 11 - 12, **wobei** der Druckgradient (ΔP) durch zusätzliche Elemente gesteuert verändert wird und die zusätzlichen Elemente eine Druckpumpe (19) und/oder ein in der Transportleitung (18) vorgesehenes Transportleitungselement (38) sind.

## Claims

1. A plasma coating apparatus (10) for coating a substrate (12) with particles (15) contained in a particle reservoir (14), comprising a metering device (16) for metering the particles (15) contained in the particle reservoir (14), at least one transport line (18) and a fully enclosed process chamber (20),
**characterized in that,**
a suction line (24) is connected to the process chamber (20), wherein a suction pump (30) is associated with the suction line (24) and a flow control valve (26) is arranged upstream of the suction pump (30), whereby a pressure gradient (ΔP) between the process chamber (20) and the particle reservoir (14) can be set such that in the process chamber (20) a process chamber pressure (P1) exists and in the particle reservoir (14) a particle reservoir pressure (P2) exists, wherein the process chamber pressure (P1) is lower than the particle reservoir pressure (P2) and a plasma coating nozzle (23) in the process chamber (20) is connected to the transport line (18) from the particle reservoir (14).

2. The plasma coating apparatus (10) according to claim 1, wherein the metering device (16) is located in a metering chamber (11) and is connected with the process chamber (20) via the transport line (18).

3. The plasma coating apparatus (10) according to claim 2, wherein the process chamber (20) is spatially separated from the metering chamber (11).

4. The plasma coating apparatus (10) according to claim 3, wherein at least one filter (28) is disposed between the flow control valve (26) and the suction pump (30).

5. The plasma coating apparatus (10) according to anyone of the claims 1 to 4, wherein the differential pressure between the particle reservoir pressure (P2) and the process chamber pressure (P1) is between 50 mbar and 1000 mbar.

6. The plasma coating apparatus (10) according to anyone of the claims 1 to 5, wherein the particle reservoir pressure (P2) is between 900 mbar and 1500 mbar.

7. The plasma coating apparatus (10) according to anyone of the claims 1 to 6, wherein the metering device (16) has a movable suction lance (25) extending into the particle reservoir (14) and connected to the transport line (18).

8. The plasma coating apparatus (10) according to anyone of the claims 1 to 7, wherein the metering chamber (11) has an additional support pump (19) associated with it that affects the metering chamber (11).

9. The plasma coating apparatus (10) according to anyone of the claims 1 to 7, wherein a transport line element (38) is provided in the transport line (18).

10. The plasma coating apparatus (10) according to claim 9, wherein the transport line element (38) is a support pump or a throttle.

11. A method for plasma coating a substrate (12), **characterized by the following steps:**
• that in a particle reservoir (14) particles are extracted in doses with a metering device (16) by means of a movable suction lance (25);
• that particles (15) are supplied via a transport line (18) to the process chamber (20), in which a plasma coating torch (21) is provided;
• that the substrate (12) is coated in the process chamber (20) and particles (15) are deposited on the substrate (12);
• that by means of a suction pump (30), which has a flow control valve (26) provided upstream, via a suction line (24) connected to the processing chamber (20) a pressure gradient (ΔP) is set between the processing chamber (20) and the particle reservoir (14),
• wherein the pressure gradient (ΔP) determines a delivery rate of particles (15) to the plasma coating torch (21) in the processing chamber (20).

12. The method according to claim 11, wherein the pressure gradient (ΔP) is set by the suction power.

13. The method according to anyone of the claims 11 to 12, wherein the pressure gradient (ΔP) is changed in a regulated way by additional elements and the additional elements are a pressure pump (19) and/or a transport line element (38) provided in the transport line (18).

## Revendications

1. Dispositif de revêtement par plasma (10) destiné au revêtement d'un substrat (12) par des particules (15) d'un réservoir de particules (14), comprenant un dispositif de dosage (16) destiné au dosage des particules (15) stockées dans le réservoir de particules (14), au moins une conduite de transport (18), et une chambre de traitement (20) fermée de tous les côtés,
**caractérisé en ce qu'**
une conduite d'aspiration (24) est reliée à la chambre de traitement (20), une pompe aspirante (30) étant associée à la conduite d'aspiration (24), et une soupape d'étranglement (26) étant disposée en amont de la pompe aspirante (30), un gradient de pression (ΔP) entre la chambre de traitement (20) et le réservoir de particules (14) pouvant ainsi être réglé de telle manière qu'une pression de chambre de traitement (P1) règne dans la chambre de traitement (20) et qu'une pression de réservoir de particules (P2) règne dans le réservoir de particules (14), la pression de chambre de traitement (P1) étant inférieure à la pression de réservoir de particules (P2), et une buse de revêtement par plasma (23) située dans la chambre de traitement (20) étant reliée à la conduite de transport (18) provenant du réservoir de particules (14).

2. Dispositif de revêtement par plasma (10) selon la revendication 1, dans lequel le dispositif de dosage (16) est logé dans une chambre de dosage (11) et est relié à la chambre de traitement (20) par la conduite de transport (18).

3. Dispositif de revêtement par plasma (10) selon la revendication 2, dans lequel la chambre de traitement (20) est séparée spatialement de la chambre de dosage (11).

4. Dispositif de revêtement par plasma (10) selon la revendication 3, dans lequel au moins un filtre (28) est disposé entre la soupape d'étranglement (26) et la pompe aspirante (30).

5. Dispositif de revêtement par plasma (10) selon l'une des revendications 1 à 4, dans lequel la pression différentielle entre la pression de réservoir de particules (P2) et la pression de chambre de traitement (P1) est comprise entre 50 mbar et 1000 mbar.

6. Dispositif de revêtement par plasma (10) selon l'une des revendications 1 à 5, dans lequel la pression de réservoir de particules (P2) est comprise entre 900 mbar et 1500 mbar.

7. Dispositif de revêtement par plasma (10) selon l'une des revendications 1 à 6, dans lequel le dispositif de dosage (16) comprend une lance d'aspiration (25) mobile qui s'étend dans le réservoir de particules (14) et est reliée à la conduite de transport (18).

8. Dispositif de revêtement par plasma (10) selon l'une des revendications 1 à 7, dans lequel une pompe de soutien (19) additionnelle est associée à la chambre de dosage (11), qui agit sur la chambre de dosage (11).

9. Dispositif de revêtement par plasma (10) selon l'une des revendications 1 à 7, dans lequel un élément de conduite de transport (38) est prévu dans la conduite de transport (18).

10. Dispositif de revêtement par plasma (10) selon la revendication 9, dans lequel l'élément de conduite de transport (38) est une pompe de soutien ou un étranglement.

11. Procédé de revêtement par plasma d'un substrat (12), **caractérisé par les étapes suivantes:**
• prélever de manière dosée des particules dans un réservoir de particules (14) par un dispositif de dosage (16), au moyen d'une lance d'aspiration (25);
• amener les particules (15) à la chambre de traitement (20), dans laquelle est prévue une torche de revêtement par plasma (21), par une conduite de transport (18);
• revêtir le substrat (12) dans la chambre de traitement (20), des particules (15) se déposant sur le substrat (12);
• régler un gradient de pression (ΔP) entre la chambre de traitement (20) et le réservoir de particules (14) par une conduite d'aspiration (24) reliée à la chambre de traitement (20), au moyen d'une pompe aspirante (30) qui est précédée d'une soupape d'étranglement (26),
• le gradient de pression (ΔP) déterminant un débit de particules (15) vers la torche de revêtement par plasma (21) située dans la chambre de traitement (20).

12. Procédé selon la revendication 11, dans lequel le gradient de pression (ΔP) est réglé par la puissance de l'aspiration.

13. Procédé selon l'une des revendications 11 à 12, dans lequel le gradient de pression (ΔP) est modifié de manière contrôlée par des éléments additionnels, les éléments additionnels étant une pompe à pression (19) et/ou un élément de conduite de transport (38) prévu dans la conduite de transport (18).
